# EUROPÄISCHE PATENTANMELDUNG

(11) **EP 1 931 133 A1**
(43) Veröffentlichungstag der Anmeldung: **11.06.2008**
(21) Anmeldenummer: 07119614.1
(22) Anmeldetag: 30.10.2007
(51) Int. Cl.: H04N 5/225

(54) **Verfahren und Vorrichtung zur optischen Erfassung einer Struktur**

(30) Priorität: 07.12.2006 DE 102006058057
(71) Anmelder: SICK AG, 79183 Waldkirch (DE)
(72) Erfinder: Wüstefeld, Martin, 79350 Sexau (DE); Mack, Stefan, 79108 Freiburg (DE); Bergbach, Roland, 79341 Kenzingen (DE); Haberer, Christoph, 79104 Freiburg (DE)
(74) Vertreter: Ludewigt, Christoph

(57) **Zusammenfassung**

Eine Struktur (10) wird mit einem Kamerasystem erfasst, durch welches die Struktur (10) auf einem Bildaufnehmer (14) abgebildet wird. Ein in dem Abbildungsstrahlengang angeordnetes optisches Element (18) bildet die Struktur in voneinander getrennten und voneinander versetzten Bereichen des Bildaufnehmers (14) ab.

## Beschreibung

Die Erfindung betrifft ein Verfahren zur optischen Erfassung einer Struktur gemäß dem Oberbegriff des Patentanspruchs 1 sowie eine Vorrichtung zur optischen Erfassung einer Struktur gemäß dem Oberbegriff des Patentanspruchs 8.

Zur optischen Erfassung von Strukturen, z.B. zur Überwachung von Gegenständen oder Raumzonen, werden Kamerasysteme verwendet, die die zu erfassende Struktur auf einem Bildaufnehmer abbilden. Die üblicherweise eingesetzten Bildaufnehmer haben ein rechteckiges oder quadratisches Format, mit welchem die Abbildung der Struktur in einer Pixel-Matrix erfasst wird. Das Seitenverhältnis des flächigen Bildaufnehmers liegt dabei zwischen 1:1 und 1:2. Diese Bildaufnehmer sind insbesondere als CCD-Sensoren kostengünstig. Diese Bildaufnehmer haben jedoch nur eine begrenzte Punktauflösung und einen begrenzten Dynamikbereich. CMOS-Sensoren können mit einer besseren Dynamik hergestellt werden, sind jedoch kostenaufwändiger und weisen ein ungünstigeres Signal-Rausch-Verhältnis auf.

Sollen Strukturen erfasst werden, deren eine Dimension langgestreckt ist in Bezug auf ihre zweite Dimension, so ist es oft erforderlich, eine stark verkleinernde Abbildung zu verwenden, damit die gesamt langgestreckte Struktur auf dem Bildaufnehmer abgebildet werden kann. Dadurch wird die Bildauflösung zwangsläufig gering. Soll eine Überwachung langgestreckter Strukturen mit hoher Auflösung durchgeführt werden, sind teuere Spezialsensoren als Bildaufnehmer erforderlich.

Es ist bekannt, entfernungsauflösende Bildaufnehmer einzusetzen, die in jedem Pixel mittels Photonmischdetektion einen Entfernungswert auf Basis eines Lichtlaufzeitverfahrens bestimmen. Die oben genannten Nachteile gelten für diese Art Matrixempfänger entsprechend. Besonders gravierend werden dies Nachteile, wenn die Anwendung einen Öffnungswinkel von 90° und mehr fordert, weil dann aufwändige Weitwinkelobjektive eingesetzt werden müssen, um überhaupt ein vollständiges Bild zu erhalten, und dennoch die schlechte Ausnutzung des matrixförmigen Bildsensors bei langgestreckten Strukturen und die durch das Seitenverhältnis bedingte relativ geringe Auflösung nicht vermieden werden.

Bei der Überwachung von Gegenständen oder Raumzonen in der Sicherheitstechnik wird häufig ein zweikanaliger Aufbau verwendet, um interne Fehlereinflüsse zu minimieren und die Zuverlässigkeit der Überwachung zu verbessern. Wird auch der Bildaufnehmer zweifach ausgeführt, so führt dies zu einem erheblichen Kostenaufwand. Es wird daher häufig der Sensorteil nur einfach ausgeführt und ein interner Test des Sensorteils durchgeführt, der wiederum die Ansprechzeit des Sensors erhöht.

Der Erfindung liegt die Aufgabe zu Grunde, die optische Erfassung von Strukturen kostengünstiger und zuverlässiger auszubilden.

Diese Aufgabe wird erfindungsgemäß gelöst durch ein Verfahren mit den Merkmalen des Patentanspruchs 1 bzw. durch eine Vorrichtung mit den Merkmalen des Patentanspruchs 8.

Vorteilhafte Ausführungen der Erfindung sind in den jeweils rückbezogenen Unteransprüchen angegeben.

Der Erfindung liegt der Gedanke zu Grunde, dass bei der Erfassung einer Struktur mit einem quadratischen oder rechteckigen Bildaufnehmer in den meisten Fällen und insbesondere bei länglichen Strukturen nur ein geringer Teil der Sensorfläche des Bildaufnehmers für die Abbildung der Struktur ausgenutzt wird, während ein wesentlicher Teil der Sensorfläche ungenutzt bleibt. Daher wird erfindungsgemäß die Matrixfläche eines insbesondere quadratischen oder rechteckigen Bildaufnehmers für die Erfassung einer Struktur dadurch ausgenutzt, dass in den Abbildungsstrahlengang des Kamerasystems ein optisches Element eingefügt wird, welches die Struktur in wenigstens zwei von einander getrennten und gegeneinander versetzten Bereichen des Bildaufnehmers abbildet.

Handelt es sich bei der zu erfassenden Struktur um eine langgestreckte Struktur, deren Längserstreckung in einer Dimension, als X-Achse bezeichnet, groß ist gegen deren Abmessung in der hierzu senkrechten Dimension, als Y-Achse bezeichnet, so erzeugt das optische Element vorzugsweise eine Abbildung der Struktur in wenigstens zwei Bereichen, die in der X-Achse verlaufen und in der zu dieser senkrechten Y-Achse gegeneinander versetzt sind. Dadurch wird es möglich, einen größeren Teil der Sensorfläche oder gegebenenfalls auch die gesamte Sensorfläche eines quadratischen oder rechteckigen Bildaufnehmers bei der Abbildung einer langgestreckten Struktur auszunutzen. Dadurch kann der gleiche Bildaufnehmer auf die jeweilige Aufgabe optimal angepasst werden, also dieselbe Hardware vielseitiger eingesetzt werden.

Die erfindungsgemäße Abbildung der Struktur in zwei oder mehr voneinander getrennten gegeneinander versetzten Bereichen kann in unterschiedlicher Weise vorteilhaft verwendet werden.

In einer Ausführung wird jeweils die gesamte Struktur auf dem Bildaufnehmer in den zwei gegeneinander versetzten Bereichen abgebildet. Hierdurch ergibt sich zwar keine Verbesserung der Auflösung, man erhält jedoch eine redundante Abbildung. Fallen einzelne Bildpunkte (Pixel) in einer der Abbildungen aus, so können diese fehlerhaften Bildpunkte einer Abbildung durch die entsprechenden Bildpunkte der versetzten zweiten Abbildung ergänzt werden. Die mehrfache redundante Abbildung der gesamten Struktur ergibt somit eine zweikanalige Überwachung mit nur einem Bildaufnehmer, so dass die Zuverlässigkeit der zweikanaligen Überwachung in kostengünstiger Weise realisiert wird.

In einer anderen Ausführung wird ebenfalls die gesamte Struktur in einem Bereich des Bildaufnehmers abgebildet. Die wenigstens eine weitere übereinstimmende Abbildung der gesamten Struktur wird in einem getrennten Bereich so abgebildet, dass sie um einen Subpixel-Abstand gegenüber dem Rasterabstand der Bildpunkte in der Matrix des Bildaufnehmers im Vergleich zu der ersten Abbildung versetzt ist. Der Versatz der Abbildung weicht somit von einem ganzzahligen Vielfachen des Pixelabstandes des Bildaufnehmers ab. Die um diesen Subpixel-Abstand gegeneinander versetzten Abbildungen derselben Struktur können dann in der Auswertung dazu verwendet werden, die Pixelauflösung der Abbildung rechnerisch zu verbessern.

In einer weiteren Ausführung kann die Ausnutzung der gesamten Sensorfläche dazu verwendet werden, die Auflösung der Abbildung einer langgestreckten Struktur zu verbessern. Hierzu wird die Abbildung der länglichen Struktur in deren Längserstreckung (X-Achse) in Einzelabschnitte unterteilt, die in der Y-Achse gegeneinander versetzt abgebildet werden. Damit kann eine langgestreckte Struktur ohne Verkleinerung oder mit geringerer Verkleinerung auf einem Bildaufnehmer abgebildet werden, dessen Längserstreckung in der X-Achse geringer ist, als die Abbildung der gesamten Struktur, ohne dass dadurch die Bildauflösung verringert wird.

Schließlich kann auch der Dynamikbereich des Bildaufnehmers erweitert werden. Hierzu wird wiederum die gesamte Struktur in einem Flächenbereich des Bildaufnehmers abgebildet und dieselbe Struktur wird jeweils auch in wenigstens einem getrennten und versetzten Bereich abgebildet. Die Lichtintensität der Belichtung des Bildaufnehmers in den gegeneinander versetzten Bereichen wird jedoch optisch unterschiedlich stark abgeschwächt. Damit kann ein großer Bereich der ursprünglichen Beleuchtungsintensität der Struktur in den verschiedenen gegeneinander versetzten Bereich stufenweise abgeschwächt werden, so dass jeweils in wenigstens einem dieser Bereiche die auf den Bildaufnehmer auftreffende Beleuchtungsintensität in den optimalen Dynamikbereich des Bildaufnehmers fällt. Wird beispielsweise in der Abbildung der Struktur mit der geringsten Intensitätsabschwächung der Bildaufnehmer an besonders hellen Stellen der Struktur übersteuert, so können ein oder mehrere weitere versetzte Bereiche mit stärkerer Abschwächung dazu ausgenutzt werden, diese in dem ersten Bereich übersteuerten Stellen der Struktur zu detektieren und zu ergänzen.

Es ist besonders bevorzugt, die erfindungsgemäße Erfassung einer Struktur zur Absicherung einer Gefahrenquelle in einem Raumbereich einzusetzen, bei dem die Struktur auf Veränderungen überwacht wird, um unzulässige Objekteingriffe in den Raumbereich zu erkennen und gegebenenfalls eine Gefahrenquelle abzusichern. In einer derartigen sicherheitstechnischen Anwendung kommen nicht nur die Vorteile der verbesserten Ausnutzung des Bildaufnehmers zur Geltung, sondern es kann bei Bedarf der Anwendung zusätzlich durch Mehrfachabbildung der ganzen Struktur oder jeweils mehrfache Abbildung von Abschnitten der Struktur auch die Anforderung der redundanten Auswertung ohne zusätzliche Hardware erfüllt werden.

Im Folgenden wird die Erfindung anhand von in der Zeichnung dargestellten Ausführungsbeispielen näher erläutert. Es zeigen
- Fig. 1: schematisch eine erste Ausführung der Erfindung;
- Fig. 2: schematisch eine zweite Ausführung der Erfindung;
- Fig. 3: schematisch eine dritte Ausführung der Erfindung;
- Fig. 4: schematisch eine vierte Ausführung der Erfindung;
- Fig. 5: schematisch eine fünfte Ausführung der Erfindung;
- Fig. 6: schematisch eine sechste Ausführung der Erfindung;
- Fig. 7: schematisch eine siebte Ausführung der Erfindung;
- Fig. 8: ein erstes Beispiel für die Ausgestaltung des optischen Elementes in der Ausführung der Figur 3;
- Fig. 9: ein zweites Beispiel für die Ausbildung des optischen Elementes in der Ausführung der Figur 3 in Seitenansicht a und in Draufsicht b;
- Fig. 10: ein drittes Beispiel für die Ausbildung des optischen Elementes in der Ausführung der Figur 3 in Draufsicht mit einer zugehörigen Ansicht aus der Ebene des Bildaufnehmers;
- Fig. 11: schematisch die optische Erfassung einer Struktur nach dem Stand der Technik; und
- Fig. 12: schematisch die Verwendung der optischen Erfassung zur Überwachung eines Sichtfeldes.

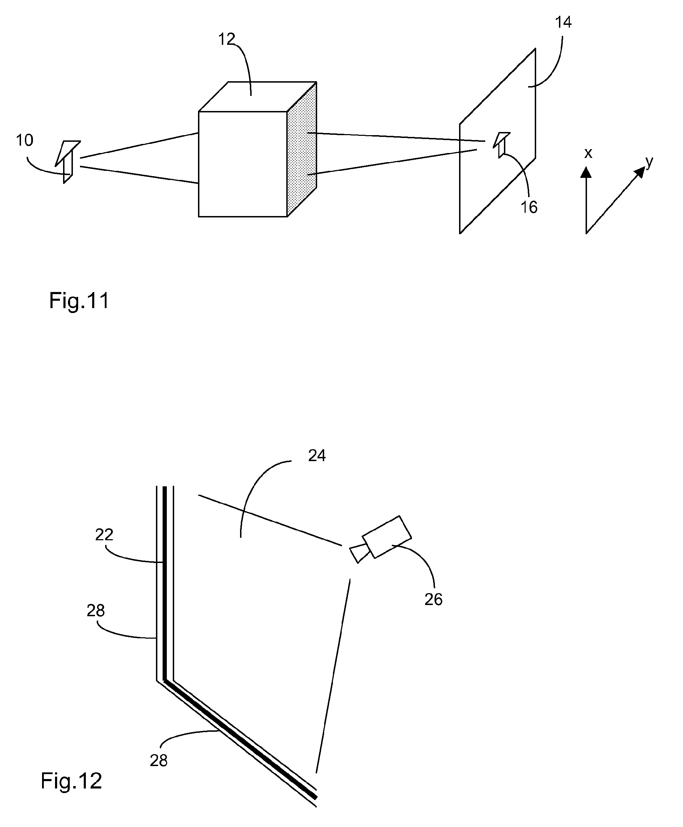

In Figur 11 ist zur Erläuterung ein Kamerasystem nach dem Stand der Technik zur Erfassung einer Struktur dargestellt.

Die Struktur 10 ist schematisch als Pfeil dargestellt, kann jedoch irgend eine Struktur sein, insbesondere eine langgestreckte Struktur, deren Ausdehnung in einer Längsrichtung (X-Achse) größer ist als ihre Bereite in der dazu senkrechten Y-Achse. Die Struktur 10 wird mit einem Kamerasystem erfasst, welches eine Abbildungsoptik 12 aufweist, die die Struktur 10 auf einen Bildaufnehmer 14 abbildet. Der Bildaufnehmer 14 ist beispielsweise ein CCD-Sensor oder ein CMOS-Sensor mit einer quadratischen oder rechteckigen Matrix von Bildpunkten (Pixel). Die Struktur 10 wird auf dem Bildaufnehmer 14 als Abbildung 16 abgebildet, die der Struktur 10 entspricht. Im Allgemeinen wird die Abbildung 16 nur einen Teilbereich der Sensorfläche des Bildaufnehmers 14 einnehmen, so dass nur dieser Teilbereich des Bildaufnehmers 14 ausgenützt wird. Insbesondere wenn die Struktur 10 eine, z.B. in der X-Achse langgestreckte Struktur ist, nutzt die Abbildung 16 nur einen in der X-Achse verlaufenden streifenförmigen Bereich des Bildaufnehmers 14 aus. Die Abbildungsoptik 12 kann gegebenenfalls so vergrößern oder verkleinern, dass die Abbildung 16 in ihrer Längserstreckung in der X-Achse die Abmessungen des Bildaufnehmers 14 in dieser X-Achse optimal ausnutzt. Die Bereiche des Bildaufnehmers 14 beiderseits der Abbildung 16 bleiben jedoch ungenutzt.

Figur 12 zeigt ein typisches Beispiel für die Verwendung der Erfassung einer langgestreckten Struktur 10 zur Überwachung eines Sichtfeldes 24. Eine Kamera 26 ist in einem Raum angeordnet, um das Sichtfeld 24 zwischen der Kamera 26 und den gegenüberliegenden Wänden 28 des Raumes zu überwachen. An den Wänden 28 ist ein Retroreflektorband 22 angebracht. Eine in der Kamera 26 angeordnete Lichtquelle beleuchtet das Retroreflektorband 22, während die Abbildungsoptik der Kamera 26 die Struktur des Retroreflektorbandes 22 auf dem Bildaufnehmer der Kamera 26 abbildet. Das Retroreflektorband 22 ist in einer Richtung langgestreckt, während es in der hierzu senkrechten Richtung schmal ist. Dementsprechend ist die Abbildung der Struktur des Retroreflektorbandes 22 langgestreckt. Änderungen der Abbildung der Struktur des Retroreflektorbandes 22 auf dem Bildaufnehmer der Kamera 26 werden als Störung des überwachten Sichtfeldes 24 erkannt, um ein entsprechendes Signal auszulösen.

Die Kamera 26 kann auch eine entfernungsauflösende Kamera sein, beispielsweise durch einen nicht dargestellten Lichtsender, der Lichtpulse oder moduliertes Licht aussendet, wobei die Lichtlaufzeit beziehungsweise die Phasenverschiebung zur Bestimmung von Entfernungen ermittelt wird. Alternativ kann aktive oder passive Triangulation zur Bestimmung von Entfernungswerten eingesetzt werden. Durch Ermittlung von Entfernungen kann mit Überwachung einer eindimensionalen Struktur eine Ebene zweidimensional erfasst werden. Durch Übereinanderschichten mehrerer solcher Ebenen, also einen Mehrebenensensor, ist eine leicht auszuwertende Approximation an eine dreidimensionale Raumüberwachung ermöglicht.

Die Überwachung des Sichtfeldes 24 erfolgt in einer besonders bevorzugten sicherheitstechnischen Anwendung zur Überwachung einer nicht dargestellten Gefahrenquelle. Dabei kann es sich um eine Presse, ein Feuer, eine Schneidkante oder jede denkbare Quelle einer Verletzungsgefahr insbesondere für Bedienpersonal handeln. Erkennt eine an die Kamera 26 angeschlossene oder in diese integrierte Auswertung einen unzulässigen, also unerwarteten Objekteingriff, etwa durch Vergleich mit einer Referenzszene oder -sequenz im Sichtbereich 24 erlaubter Objekte, so schaltet sie einen Ausgang, der einen Alarm auslöst oder unmittelbar einen Abschalt- oder Absicherungsbefehl an die Gefahrenquelle erzeugt, so dass diese abgeschaltet oder sonst in einen sicheren Zustand gebracht wird.

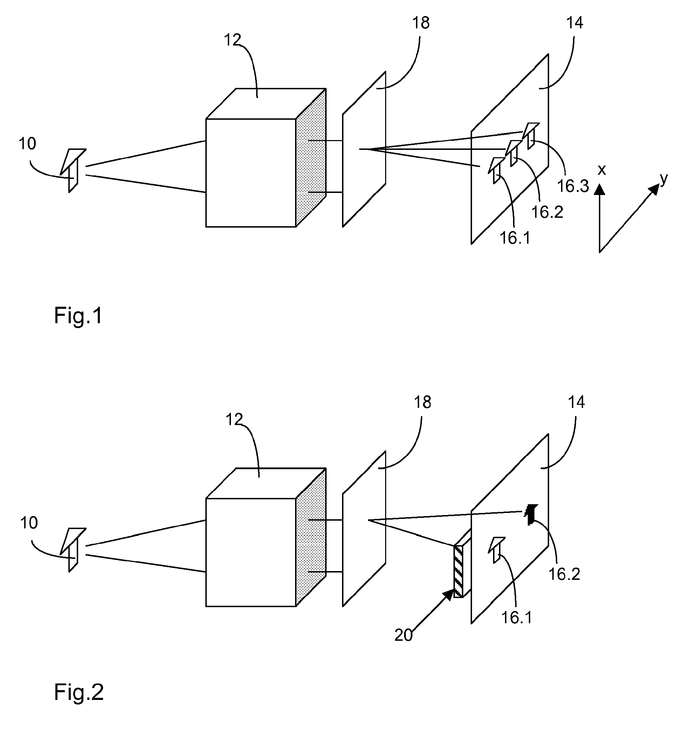

In den Figuren 1 bis 9 sind in schematischer Darstellung Ausführungsbeispiele der Erfindung gezeigt. Soweit diese Ausführungen mit dem Stand der Technik gemäß Figur 11 und 12 übereinstimmen, sind dieselben Bezugszeichen verwendet.

In dem Ausführungsbeispiel der Figur 1 ist in den Abbildungsstrahlengang des Kamerasystems ein optisches Element 18 eingesetzt. Das optische Element 18 dient dazu, die Abbildungsstrahlen in unterschiedliche Bereiche des Bildaufnehmers 14 abzulenken. Das optische Element 18 kann in unterschiedlicher Weise ausgebildet sein, wie später im Einzelnen beschrieben wird. Das optische Element 18 kann vor der Abbildungsoptik 12 oder zwischen der Abbildungsoptik 12 und dem Bildaufnehmer 14 vor dem Bildaufnehmer 14 angeordnet sein. Eine Anordnung des optischen Elementes 18 nach der Abbildungsoptik 12 und vor dem Bildaufnehmer 14 hat dabei den Vorteil, dass die Lage der Abbildungen 16 auf dem Bildaufnehmer 14 von der Objektivweite der Abbildungsoptik 12 unabhängig ist.

In dem Ausführungsbeispiel der Figur 1 ist das optische Element 18 so ausgebildet, dass es die Abbildungsstrahlen der Struktur 10 senkrecht zu der Längserstreckung (X-Achse) der Struktur 10 unterschiedlich stark in der Y-Achse ablenkt. Anstelle einer einzigen Abbildung 16 der Struktur 10 werden auf diese Weise zwei oder mehr, im dargestellten Ausführungsbeispiel drei Abbildungen 16.1, 16.2 und 16.3, erhalten. Diese Abbildungen 16.1, 16.2 und 16.3 stellen jeweils Abbildungen der vollständigen Struktur 10 dar und liegen in der Y-Achse voneinander getrennt. Die Abbildungen 16.1, 16.2 und 16.3 werden von dem Bildaufnehmer 14 erfasst und können in einer nachgeschalteten Bildauswertung als redundante Abbildungen der Struktur 10 verarbeitet werden. Treten in einer der Abbildungen 16.1, 16.2 und 16.3 in einzelnen Bildpunkten Fehler oder Störungen auf, so können die entsprechenden Bildpunkte einer anderen Abbildung verwendet werden. Dadurch ergibt sich eine wesentliche Erhöhung der Sicherheit der Erfassung der Struktur 10.

Sind die Abbildungen 16.1, 16.2 und 16.3 in den voneinander getrennten Bereichen um einen ganzzahligen Pixel-Abstand des Bildaufnehmers 14 voneinander getrennt, so ergeben sich in diesen voneinander getrennten Bereichen jeweils identische Abbildungen 16.1, 16.2 und 16.3 der Struktur 10, wie dies für die Verwendung als redundante Abbildungen zweckmäßig ist. In einer abgewandelten Ausführung kann die Ablenkung der Abbildungsstrahlen so gewählt sein, dass die Abbildungen 16.1, 16.2 und 16.3 gegeneinander, im dargestellten Beispiel in der Y-Achse, um einen Abstand versetzt sind, der von einem ganzzahligen Vielfachen des Pixel-Abstandes des Bildaufnehmers 14 abweicht. In den voneinander getrennten Bereichen werden daher Abbildungen 16.1, 16.2 und 16.3 erfasst, die in Bezug auf die Matrix des Bildaufnehmers 14 um Subpixel-Abstände gegeneinander versetzt sind. Solche um Subpixel-Abstände gegeneinander versetzte Abbildungen 16.1, 16.2 und 16.3 können dazu ausgenützt werden, die Pixel-Auflösung des Bildaufnehmers 14 in der nachgeschalteten Bildauswertung rechnerisch zu verbessern.

Figur 2 zeigt eine weitere Anwendung der Erfindung. Das optische Element 18 spaltet in dem dargestellten Ausführungsbeispiel die Abbildungsstrahlen in der Y-Achse in zwei Abbildungen 16.1 und 16.2 auf, die gegeneinander versetzt und voneinander getrennt sind. Vor dem Bildaufnehmer 14 ist ein optischer Abschwächer 20 angeordnet, der die Intensität der Abbildungsstrahlen stufenweise abschwächt. Der Abschwächer 20 ist dabei so ausgebildet und angeordnet, dass er die Abbildungsstrahlen jeder Abbildung 16.1. bzw. 16.2 unterschiedlich stark abschwächt. Beispielsweise werden die Abbildungsstrahlen der Abbildung 16.1 wenig oder gar nicht abgeschwächt, während die Abbildungsstrahlen der Abbildung 16.2 stärker abgeschwächt werden. Damit kann der Dynamikbereich des Bildaufnehmers 14 erweitert werden. Wird der Bildaufnehmer 14 z.B. an gewissen Stellen der nicht oder wenig abgeschwächten Abbildung 16.1 übersteuert, so werden diese Helligkeitsstellen in der Abbildung 16.2 durch die stärkere Abschwächung des Abschwächers 20 in einen Intensitätsbereich gebracht, der der Dynamik des Bildaufnehmers 14 angepasst ist. Selbstverständlich können auch mehr als zwei Abbildungen 16.1, 16.2 mit mehreren Intensitätsabstufungen des Abschwächers 20 verwendet werden, um den Dynamikbereich noch weiter zu vergrößern oder die auftreffende Lichtintensität feiner auf die Dynamik des Bildaufnehmers 14 abzustimmen.

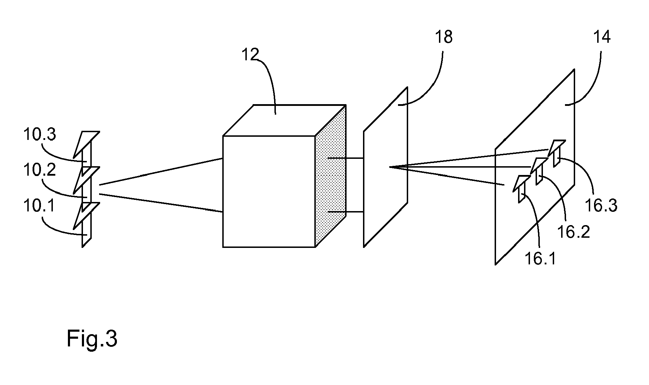

Figur 3 zeigt eine weitere Anwendung der Erfindung. Um die Abmessung des Bildaufnehmers 14 in der X-Achse optimal für die Abbildung einer Struktur 10 auszunutzen, die eine große Längserstreckung in der X-Achse aufweist, ist das optische Element 18 so ausgebildet, dass in der Richtung der X-Achse aufeinanderfolgende Teilabschnitte 10.1, 10.2 und 10.3 der Struktur 10 auf dem Bildaufnehmer 14 in Teilabbildungen 16.1., 16.2 und 16.3 abgebildet werden, die in der Y-Achse gegeneinander versetzt und beabstandet angeordnet sind. Dadurch kann eine Struktur 10 mit großer Länge in der X-Achse auf einem Bildaufnehmer 14 mit geringerer X-Abmessung abgebildet werden, ohne dass durch eine Verkleinerung der Abbildung die Bildauflösung verringert werden muss.

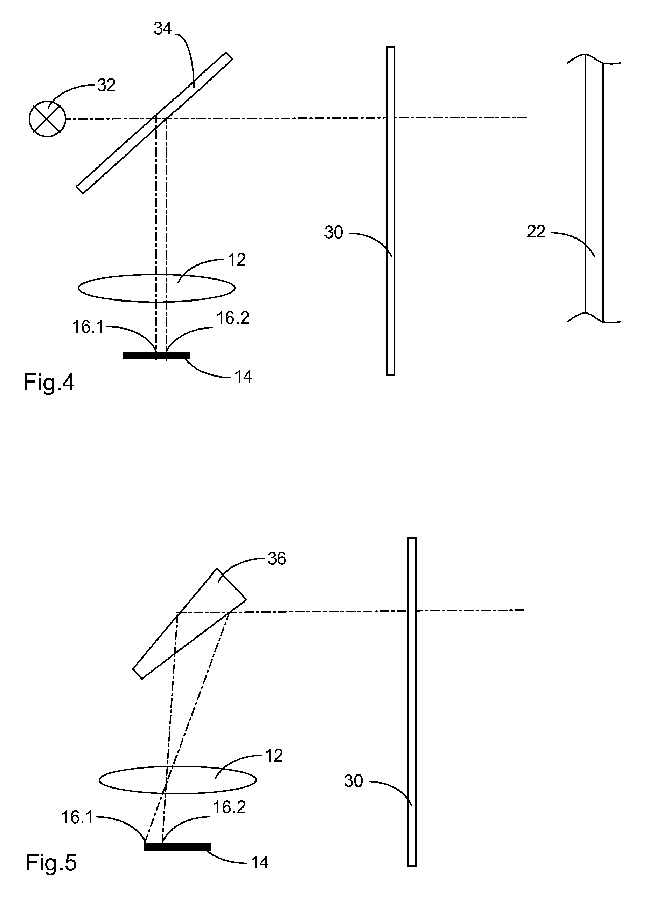

Eine weitere Anwendung der Erfindung ist in Figur 4 schematisch dargestellt. Ein Kamerasystem weist ein durch eine transparente Frontscheibe 30 abgeschlossenes Gehäuse auf. In dem Gehäuse befindet sich eine Lichtquelle 32, die durch die Frontscheibe 30 einen Retroreflektor 22 anstrahlt. In dem Gehäuse ist als optisches Element eine planparallele doppelt reflektierende Umlenkplatte 34 angeordnet, die gegen die optische Achse des Kamerasystems z.B. unter einem Winkel von 45° schräg gestellt ist. Die von dem Retroreflektor 22 reflektierten Abbildungsstrahlen treffen auf die Umlenkplatte 34 und werden dabei jeweils teilweise an der vorderen Fläche und an der hinteren Fläche der Umlenkplatte 34 reflektiert, so dass der Abbildungsstrahl in zwei parallele gegeneinander versetzte Abbildungsstrahlen geteilt wird, die durch die Abbildungsoptik 12 auf dem Bildaufnehmer 14 abgebildet werden. Auf diese Weise wird die Struktur des Retroreflektors 22 auf zwei voneinander getrennte und gegeneinander versetzte Bereiche des Bildaufnehmers 14 als Abbildungen 16.1 und 16.2 abgebildet.

Die Aufspaltung der Abbildung der Struktur des Retroreflektors 22 in zwei getrennte Abbildungen 16.1 und 16.2 ermöglicht eine zweikanalige Überwachung des Sichtfeldes vor dem Retroreflektor 22 mit nur einem Bildaufnehmer 14. Die nachgeschaltete Auswertung der zwei getrennten Abbildungen 16.1 und 16.2 ergibt eine redundante Überwachung, die eine erhöhte Zuverlässigkeit gegen interne Störungen gewährleistet.

Figur 5 zeigt eine gegenüber dem Ausführungsbeispiel der Figur 4 abgewandelte Ausführung. Anstelle der planparallelen Umlenkplatte 34 ist ein doppelreflektierendes Umlenkprisma 36 als optisches Element vorgesehen. Die reflektierende Vorderfläche und Rückfläche des Umlenkprismas 36 stehen unter einem Winkel zueinander, so dass die Abbildungsstrahlen an der Vorderfläche und an der Rückfläche mit einem unterschiedlichen Winkel reflektiert werden, wodurch sich die Aufspaltung der Abbildung in zwei getrennte und versetzte Bereiche des Bildaufnehmers 14 ergibt.

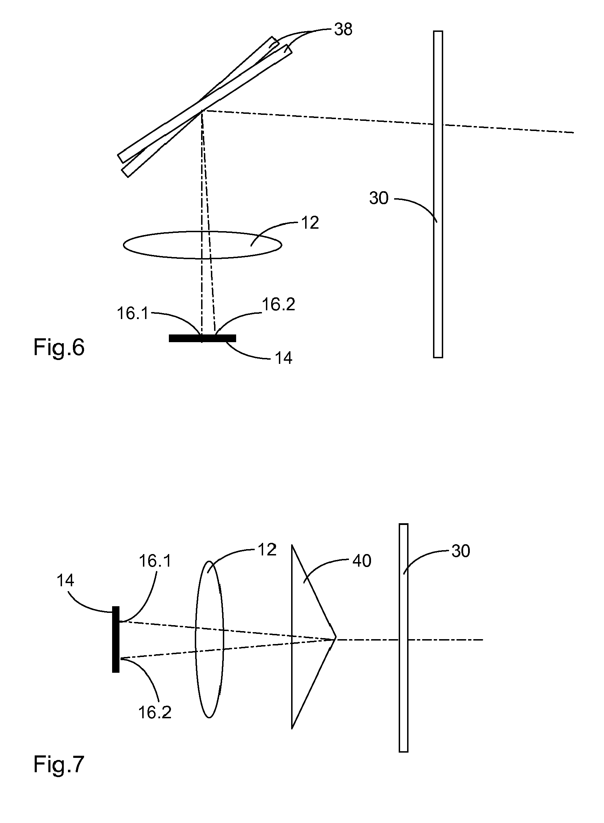

Figur 6 zeigt eine weitere Abwandlung der Ausführung der Figur 4. In der Ausführung der Figur 6 sind zwei Spiegelflächen 38 nebeneinander vorgesehen, die um einen unterschiedlichen Winkel gegen die Strahlrichtung des einfallenden Abbildungsstrahles geneigt sind. Der Abbildungsstrahl wird an den zwei Spiegelflächen 38 entsprechend deren unterschiedlichen Neigungswinkeln in unterschiedliche Richtungen reflektiert, so dass sich auf dem Bildaufnehmer 14 zwei gegeneinander versetzte getrennte Abbildungen 16.1 und 16.2 ergeben.

Eine weitere Ausbildung ist in Figur 7 gezeigt. Hier ist in den Strahlengang des einfallenden Abbildungsstrahles ein Doppelprisma 40 eingesetzt, durch welches der Abbildungsstrahl durchtritt. Entsprechend dem unterschiedlichen Keilwinkel der beiden Teile des Doppelprismas 40 wird der eintretende Abbildungsstrahl in zwei Abbildungsstrahlen mit unterschiedlichem Austrittswinkel aufgeteilt, die auf dem Bildaufnehmer 14 zwei voneinander getrennte und gegeneinander versetzte Abbildungen 16. und 16.2 erzeugen.

Die verschiedenen Ausbildungen des optischen Elementes 18 als doppelreflektierende Umlenkplatte 34 in Figur 4, als Umlenkprisma 36 in Figur 5, als doppelt geneigte Spiegelflächen 38 in Figur 6 und als Doppelprisma 40 in Figur 7 können für eine redundante doppelte Abbildung zur verbesserten Zuverlässigkeit einer Überwachung verwendet werden, für eine Verbesserung der Pixel-Auflösung oder für eine Erweiterung des Dynamik-Bereichs des Bildaufnehmers 14.

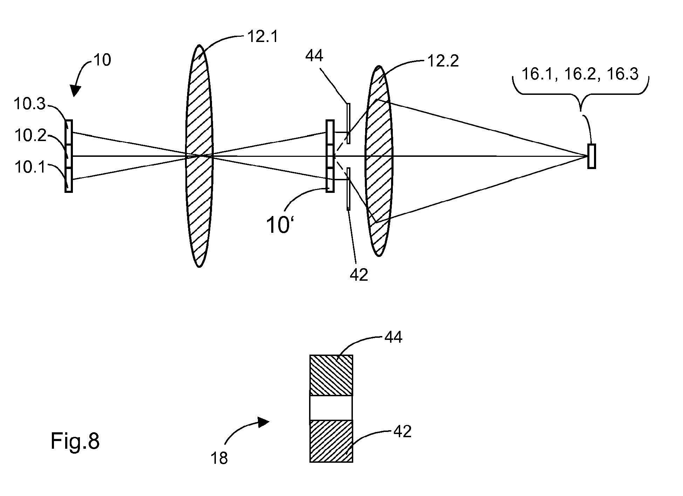

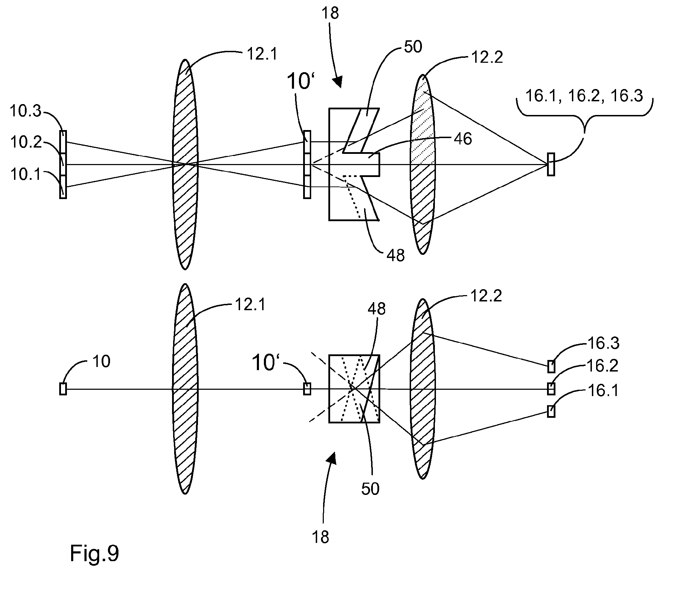

Um eine langgestreckte Struktur 10 in einzelne Abschnitte 10.1, 10.2, 10.3 unterteilt in getrennten Bildbereichen als Teilabbildungen 16.1, 16.2, 16.3 abzubilden, wie dies schematisch in Figur 3 gezeigt ist, kann das optische Element 18 z.B. in den Ausführungen der Figur 8 und Figur 9 ausgebildet sein.

In dem Ausführungsbeispiel der Figur 8 wird durch eine erste Abbildungsoptik 12.1 ein Zwischenbild 10' der Struktur 10 erzeugt. Nahe an diesem Zwischenbild 10' wird das optische Element 18 angeordnet. Das optische Element 18 ist dabei so ausgebildet, dass jeder Abschnitt 10.1, 10.2, 10.3 des Zwischenbildes 10' mit einem Bereich des optischen Elementes 18 zur Deckung kommt. In dem in Figur 8 dargestellten Beispiel bleibt der Bereich des mittleren Abschnittes 10.2. des Zwischenbildes 10' frei, so dass die Abbildungsstrahlen dieses Teilabschnitts 10.2 unbeeinflusst durch das optische Element 18 durchtreten können. Die beiden angrenzenden Bereiche 10.1 und 10.3 des Zwischenbildes 10' werden durch optische Gitter 42 und 44 abgedeckt. Wie die axiale Ansicht des optischen Elements 18 in Figur 8 unten zeigt, sind die optischen Gitter 42 und 44 jeweils unter 45° schräg gestellt, wobei das optische Gitter 42 und das optische Gitter 44 gegeneinander unter einem Winkel von 90° gestellt sind. Dadurch werden die Abbildungen 16.1 und 16.3 seitlich in unterschiedlichen Richtungen abgelenkt, so dass diese Abbildungen 16.1 und 16.3 beiderseits neben der Abbildung 16.2 des mittleren Teilabschnittes der Struktur 10 auf dem Bildaufnehmer 14 abgebildet werden, wie dies der Prinzipdarstellung der Figur 3 entspricht. Zur Fokussierung der Abbildung auf dem Bildaufnehmer 14 dient eine zweite Abbildungsoptik 12.2.

In Figur 9 ist in der oberen Abbildung a) eine Seitenansicht und in der unteren Abbildung b) eine Draufsicht der Vorrichtung dargestellt. Bis auf die Ausbildung des optischen Elementes 18 entspricht die Ausführung der Figur 9 der zuvor beschriebenen Ausführung der Figur 8.

Das optische Element 18 ist in der Ausführung der Figur 9 als Zweifach-Prisma ausgebildet, welches unmittelbar angrenzend an das Zwischenbild 10' angeordnet ist. Der dem mittleren Teilabschnitt des Zwischenbildes 10' zugeordnete mittlere Bereich 46 des optischen Elements 18 ist mit planparallelen Flächen ausgebildet, so dass die Abbildungsstrahlen des mittleren Teilabschnittes 10.2 unbeeinflusst durchtreten können. Den beiden angrenzenden äußeren Teilabschnitten 10.1 und 10.2 des Zwischenbildes 10' ist jeweils ein Teilprisma 48 bzw. 50 zugeordnet, wobei die Prismaflächen dieser Teilprismen 48 und 50 sowohl gegen die Achse der Längserstreckung (X-Achse) als auch gegen die Achse der Quererstreckung (Y-Achse) des Zwischenbildes 10' geneigt sind. Die beiden Teilprismen 48 und 50 sind dabei gegeneinander unterschiedlich geneigt. Dadurch lenken die Teilprismen 48 und 50 die Abbildungsstrahlen der ihnen jeweils zugeordneten Teilabschnitte 10.1 und 10.2 des Zwischenbildes 10' auf dem Bildaufnehmer 14 in getrennte Abbildungsbereiche ab, die in der Y-Achse gegen die Abbildung 16.2 des mittleren Teilabschnittes 10.2 nach rechts bzw. nach links versetzt sind, wie dies der schematischen Darstellung der Figur 3 entspricht.

Es ist für den Fachmann erkennbar, dass die Aufteilung und Umlenkung der Abbildungsstrahlen für die Abbildungen 16.1, 16.2, 16.3 der Teilabschnitte 10.1, 10.2, 10.3 der Struktur 10 auch durch entsprechend gestaltete andere optische Elemente 18, z.B. mit Spiegelflächen realisiert werden können. Wichtig ist dabei jeweils, dass das optische Element 18 in der Nähe des Zwischenbildes 10' angeordnet wird, damit die Abschnitte 10.1, 10.2, 10.3 des Zwischenbildes 10' getrennt auf dem Bildaufnehmer 14 abgebildet werden. Hierfür ist es z.B. auch möglich, das optische Element 18 durch Lichtleitfasern zu realisieren, die die entsprechenden Bereiche der Teilabschnitte des Zwischenbildes zu verschiedenen Teilbereichen des Bildaufnehmers 14 führen.

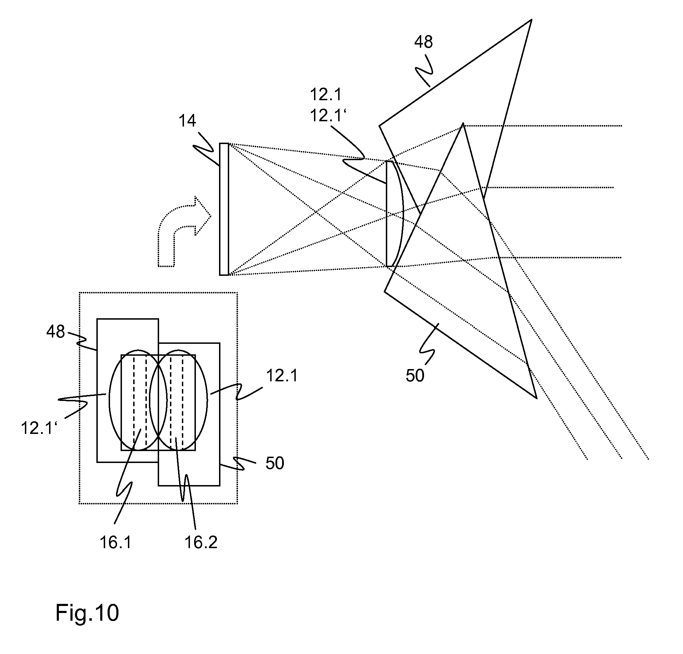

In einem weiteren Ausführungsbeispiel gemäß Figur 10 wird nur eine Linse 12.1 eingesetzt, also kein Zwischenbild bei dem optischen Element 18 erzeugt. Davon abgesehen ist die Grundidee diejenige der Ausführungsform gemäß Figur 9. In der besonders einfachen optischen Realisierung werden zwei übereinanderliegende Prismen 48, 50 gegeneinander verdreht, so dass jedes Prisma oder Teilprisma 48, 50 in etwa den halben Sichtbereich 24 auf den gesamten Bildaufnehmer 14 abbildet. Dies ist zur Vereinfachung der Darstellung mit gestrichelten Linien nur für eines der beiden Prismen 50 eingezeichnet. Jedem Prisma 48, 50 ist jeweils eine Abbildungsoptik 12.1, 12.1' zugeordnet. Sind die Prismen 48, 50 so ausgebildet, dass sie für einen Versatz von 22,5° sorgen, so ergibt sich in Kombination mit einer Optik, die einen Überwachungswinkel von 45° hat, in Summe ein Sichtwinkel von 90°. Eine 45°-Optik ist wegen der geringeren geforderten Linsenzahl mit weniger strengen Toleranzanforderungen deutlich einfacher, lichtstärker und kostengünstiger herstellbar als eine 90°-Optik. Zudem kann eine um einen Faktor 2 höhere Brennweite gewählt werden, was vor allem entscheidend ist, wenn die Pixel des Bildaufnehmers 14 besonders groß sind und ihre Anzahl gering ist.

Mit einer derartigen in der Draufsicht dargestellten Prismenanordnung 48, 50 erreicht man eine Verschiebung zweier Teile der Struktur 10 in einer Ebene. Im linken Teil der Figur 10 ist die Situation aus der Ebene des Bildaufnehmers 14 dargestellt, wo die abgebildeten Abschnitte 16.1, 16.2 der Struktur 10 auch noch in einer dazu senkrechten Ebene verschoben sind, damit sie auf dem Bildaufnehmer 10 übereinander zu liegen kommen. Um das zu erreichen, muss auch in einer Ebene senkrecht zu der Papierebene eine Lichtablenkung stattfinden, beispielsweise indem die Prismen 48, 50 als Doppelprismen ausgebildet sind, die in dieser senkrechten Ebene entsprechend gegeneinander verkippt sind.

Die Empfangsoptiken 12.1, 12.1' schließen bevorzugt direkt aneinander an und ihre optischen Achsen liegen jeweils ungefähr im Zentrum ihres jeweiligen zugehörigen Segments auf dem Bildaufnehmer 14. Diese zugehörigen Segmente, also die Pixel, auf denen jeweils ein Abschnitt der Struktur 10 abgebildet wird, können nach der Montage eingelernt werden, um eine nahezu gleiche Empfangsebene zu gewährleisten. Das erleichtert die Justierung und erlaubt den Einsatz einfacherer Optiken.

Die Prismen 48, 50 können in die Linsen 12.1, 12.1' oder in ein Deckglas des Bildaufnehmers14 integriert werden, indem entsprechende Spritzgussstrukturen vorgesehen werden. Sie schließen bevorzugt in der Ebene senkrecht zur Papierebene unmittelbar aneinander an und sitzen vor der Empfangsoptik. Die Prismen 48, 50 können als Stufenprisma mit Sägezahn ausgeführt sein, um eine geringere Materialdicke zu erreichen.

Auch in der Ausführungsform ohne Zwischenbild 10' können anstelle eines Prismas andere optische Elemente 18 eingesetzt werden, etwa Spiegel, Gitter oder diffraktive optische Elemente in Transmission oder Reflexion.

### Bezugszeichenliste

- 10: Struktur
- 12: Abbildungsoptik
- 14: Bildaufnehmer
- 16: Abbildung
- 18: optisches Element
- 20: Abschwächer
- 22: Retroreflektor
- 24: Sichtfeld
- 26: Kamera
- 28: Wände
- 30: Umlenkprisma
- 32: Lichtquelle
- 34: Umlenkplatte
- 36: Umlenkprisma
- 38: Spiegelflächen
- 40: Doppelprisma
- 42: optisches Gitter
- 44: optisches Gitter
- 46: mittlerer Bereich
- 48, 50: Teilprismen

## Patentansprüche

1. Verfahren zur optischen Erfassung einer Struktur, bei welchem die Struktur auf einem Bildaufnehmer abgebildet wird,
**dadurch gekennzeichnet, dass** ein in dem Abbildungstrahlengang angeordnetes optisches Element die Struktur in wenigstens zwei voneinander getrennten und gegeneinander versetzten Bereichen des Bildaufnehmers abbildet.

2. Verfahren nach Anspruch 1,
wobei die wenigstens zwei Bereiche parallel zueinander und quer zueinander versetzt angeordnet sind.

3. Verfahren nach Anspruch 1 oder 2,
wobei in den wenigstens zwei voneinander getrennten Bereichen jeweils die gesamte Struktur abgebildet wird.

4. Verfahren nach Anspruch 1 oder 2,
wobei die Struktur in Abschnitte unterteilt wird und diese Abschnitte jeweils wenigstens einmal in voneinander getrennten Bereichen abgebildet werden.

5. Verfahren nach einem der vorhergehenden Ansprüche,
wobei die Abbildungen in den voneinander getrennten Bereichen als redundante Abbildungen zur Erhöhung der Zuverlässigkeit der Erfassung verarbeitet werden.

6. Verfahren nach einem der vorhergehenden Ansprüche,
wobei in den gegeneinander versetzten Bereichen die Abbildung der Struktur gegenüber dem Bildaufnehmer um einen unterschiedlichen Subpixel-Abstand versetzt ist und/oder wobei die Lichtintensität der Abbildungsstrahlen für wenigstens zwei Abbildungen in gegeneinander versetzten Bereichen unterschiedlich stark geschwächt wird.

7. Verfahren zur Absicherung einer Gefahrenquelle in einem Raumbereich, bei dem eine Struktur auf Veränderungen überwacht wird, um unzulässige Objekteingriffe in den Raumbereich zu erkennen, wobei die Struktur mit einem Verfahren nach einem der Ansprüche 1 bis 7 optisch erfasst wird, insbesondere entfernungsauflösend.

8. Vorrichtung zur optischen Erfassung einer Struktur (10) mit einem Kamerasystem, das einen Bildaufnehmer (14) aufweist, auf welchem die Struktur (10) abgebildet wird,
**gekennzeichnet durch** ein optisches Element (18), das in dem Abbildungsstrahlengang angeordnet ist und die Abbildungsstrahlen der Struktur (10) in wenigstens zwei voneinander getrennte und gegeneinander versetzte Bereiche des Bildaufnehmers (14) ablenkt.

9. Vorrichtung nach Anspruch 8,
**dadurch gekennzeichnet, dass** bei der Abbildung einer langgestreckten Struktur (10) die gegeneinander versetzten Bereiche des Bildaufnehmers (14) zur Längserstreckung der Struktur (X-Achse) parallel verlaufen und quer zur Längserstreckung der Struktur (Y-Achse) gegeneinander versetzt sind.

10. Vorrichtung nach Anspruch 8 oder 9,
**dadurch gekennzeichnet, dass** das optische Element (18) in den wenigstens zwei Bereichen jeweils eine Abbildung (16.1, 16.2, 16.3) der gesamten Struktur (10) erzeugt.

11. Vorrichtung nach einem der Ansprüche 8 bis 10,
**dadurch gekennzeichnet, dass** das optische Element (18) in den wenigstens zwei Bereichen jeweils eine Abbildung (16.1, 16.2, 16.3) der gesamten Struktur (10) erzeugt, wobei diese Abbildungen (16.1, 16.2, 16.3) um einen Abstand gegeneinander versetzt sind, der von einem ganzzahligen Vielfachen des Pixel-Abstandes des Bildaufnehmers (14) abweicht.

12. Vorrichtung nach einem der Ansprüche 8 bis 10,
**dadurch gekennzeichnet, dass** in den den gegeneinander versetzten Bereichen zugeordneten Strahlengängen ein optischer Abschwächer (20) angeordnet ist, der die Intensität der diesen Bereichen jeweils zugeordneten Abbildungsstrahlen unterschiedlich abschwächt.

13. Vorrichtung nach Anspruch 8 oder 9,
**dadurch gekennzeichnet, dass** das optische Element (18) die Struktur (10) in Längsabschnitte (10.1, 10.2, 10.3) unterteilt in den gegeneinander versetzten Bereichen abbildet.

14. Vorrichtung nach einem der Ansprüche 8 bis 13,
**dadurch gekennzeichnet, dass** das optische Element (18) wenigstens ein optisches Gitter, ein Prisma, einen Spiegel oder ein diffraktives optisches Element aufweist, wobei das optische Element (18) insbesondere in eine Abbildungsoptik (12) des Bildaufnehmers (14) integriert ist.

15. Optoelektronischer Sensor, insbesondere entfernungsauflösender Sensor, zur Absicherung einer Gefahrenquelle in einem Raumbereich, bei dem eine Auswertungseinheit dafür ausgebildet ist, eine Struktur auf Veränderungen zu überwachen, um unzulässige Objekteingriffe in den Raumbereich zu erkennen, und der eine Warn- oder Abschalteeinrichtung aufweist, welche mit der Auswertungseinheit verbunden ist und welche die Gefahrenquelle absichern kann,
wobei der Sensor eine Vorrichtung nach einem der Ansprüche 8 bis 14 aufweist, um die Struktur optisch zu erfassen.

## Geänderte Patentansprüche

### Geänderte Patentansprüche gemäss Regel 137(2) EPÜ.

**1.** Verfahren zur optischen Erfassung einer Struktur, bei welchem die Struktur auf einem Bildaufnehmer abgebildet wird, wobei ein in dem Abbildungsstrahlengang angeordnetes optisches Element die Struktur in wenigstens zwei voneinander getrennten und gegeneinander versetzten Bereichen des Bildaufnehmers abbildet, **dadurch gekennzeichnet, dass** die Struktur in Abschnitte unterteilt wird und diese Abschnitte jeweils wenigstens einmal in voneinander getrennten Bereichen abgebildet werden.

**2.** Verfahren nach Anspruch 1,
wobei die wenigstens zwei Bereiche parallel zueinander und quer zueinander versetzt angeordnet sind.

**3.** Verfahren nach Anspruch 1 oder 2,
wobei die Abbildungen in den voneinander getrennten Bereichen als redundante Abbildungen zur Erhöhung der Zuverlässigkeit der Erfassung verarbeitet werden.

**4.** Verfahren nach einem der vorhergehenden Ansprüche,
wobei in den gegeneinander versetzten Bereichen die Abbildung der Struktur gegenüber dem Bildaufnehmer um einen unterschiedlichen Subpixel-Abstand versetzt ist und/oder wobei die Lichtintensität der Abbildungsstrahlen für wenigstens zwei Abbildungen in gegeneinander versetzten Bereichen unterschiedlich stark geschwächt wird.

**5.** Verfahren zur Absicherung einer Gefahrenquelle in einem Raumbereich, bei dem eine Struktur auf Veränderungen überwacht wird, um unzulässige Objekteingriffe in den Raumbereich zu erkennen, wobei die Struktur mit einem Verfahren nach einem der Ansprüche 1 bis 4 optisch erfasst wird, insbesondere entfernungsauflösend.

**6.** Vorrichtung zur optischen Erfassung einer Struktur (10) mit einem Kamerasystem, das einen Bildaufnehmer (14) aufweist, auf welchem die Struktur (10) abgebildet wird, wobei ein optisches Element (18) in dem Abbildungsstrahlengang angeordnet ist und die Abbildungsstrahlen der Struktur (10) in wenigstens zwei voneinander getrennte und gegeneinander versetzte Bereiche des Bildaufnehmers (14) ablenkt, **dadurch gekennzeichnet, dass** das optische Element (18) die Struktur (10) in Längsabschnitte (10.1, 10.2, 10.3) unterteilt in den gegeneinander versetzten Bereichen abbildet.

**7.** Vorrichtung nach Anspruch 6,
**dadurch gekennzeichnet, dass** bei der Abbildung einer langgestreckten Struktur (10) die gegeneinander versetzten Bereiche des Bildaufnehmers (14) zur Längserstreckung der Struktur (X-Achse) parallel verlaufen und quer zur Längserstreckung der Struktur (Y-Achse) gegeneinander versetzt sind.

**8.** Vorrichtung nach Anspruch 6 oder 7, **dadurch gekennzeichnet, dass** in den den gegeneinander versetzten Bereichen zugeordneten Strahlengängen ein optischer Abschwächer (20) angeordnet ist, der die Intensität der diesen Bereichen jeweils zugeordneten Abbildungsstrahlen unterschiedlich abschwächt.

**9.** Vorrichtung nach einem der Ansprüche 6 bis 8,
**dadurch gekennzeichnet, dass** das optische Element (18) wenigstens ein optisches Gitter, ein Prisma, einen Spiegel oder ein diffraktives optisches Element aufweist, wobei das optische Element (18) insbesondere in eine Abbildungsoptik (12) des Bildaufnehmers (14) integriert ist.

**10.** Optoelektronischer Sensor, insbesondere entfernungsauflösender Sensor, zur Absicherung einer Gefahrenquelle in einem Raumbereich, bei dem eine Auswertungseinheit dafür ausgebildet ist, eine Struktur auf Veränderungen zu überwachen, um unzulässige Objekteingriffe in den Raumbereich zu erkennen, und der eine Warn- oder Abschalteeinrichtung aufweist, welche mit der Auswertungseinheit verbunden ist und welche die Gefahrenquelle absichern kann,
wobei der Sensor eine Vorrichtung nach einem der Ansprüche 6 bis 9 aufweist, um die Struktur optisch zu erfassen.
